# EUROPEAN PATENT APPLICATION

(11) **EP 4 571 379 A1**
(43) Date of publication of application: **18.06.2025**
(21) Application number: 24218284.8
(22) Date of filing: 09.12.2024
(51) Int. Cl.: G02B 6/42, H01L 23/00, H01L 25/16

(54) **SEMICONDUCTOR PACKAGE WITH OPTICAL BRIDGE AND METHOD OF MANUFACTURING THE SAME**

(30) Priority: 15.12.2023 US 202363610521 P; 10.10.2024 US 202418912098
(71) Applicant: Samsung Electronics Co., Ltd., Suwon-si, Gyeonggi-do 16677 (KR)
(72) Inventor: ESLAMPOUR, Hamid, San Jose, CA, 95134 (US)
(74) Representative: Kuhnen & Wacker Patent- und Rechtsanwaltsbüro PartG mbB

(57) **Abstract**

Provided is a semiconductor package including a redistribution layer, a plurality of through mold vias on the redistribution layer, a photonics integrated circuit on the redistribution layer, a first mold on the redistribution layer, on the through mold vias, and the photonics integrated circuit, a first semiconductor chip and a second semiconductor chip on the redistribution layer opposite to the through mold vias, a first glass protruding from the second surface of the redistribution layer and penetrating the redistribution layer, a second mold layer the redistribution layer, on the first semiconductor chip, on the second semiconductor chip, and on the first glass, and a second glass that is connected to fiber on the first glass.

## Description

### BACKGROUND

### 1. Field

Example embodiments of the present disclosure relate to a method of manufacturing a semiconductor package with a photonics integrated circuit connected to fiber through index matched glasses and an apparatus thereof.

### 2. Description of Related Art

Due to the demands for higher computing performance, a high bandwidth is required to integrate a greater number of central processing units (CPUs), graphical processing units (GPUs), high bandwidth memories (HBMs), artificial intelligence (AI) chips, etc. in a single semiconductor package.

Photonics transceiver modules enable higher bandwidth data transportation and communication by using coherent light, which results in lower loss and attenuation as compared to, for example, copper wires. Photonics transceiver modules have been applied in, for example, data centers and Ethernet communication. However, photonics transceiver modules generally have been provided at a periphery of semiconductor packages, which limits an ability of the photonics transceiver modules for data communication between the photonics transceiver modules and an integrated circuit (IC) package of semiconductor chips. Integration of these photonics transceiver module with the semiconductor chips such as CPU, an application-specific integrated circuit (ASIC), and memory chips has been difficult due to the constraints that the photonics transceiver modules impose on packaging and its manufacturing processes, which arise from the need for fiber integration.

An on-package level integration of photonics modules attached to fiber is needed to provide a semiconductor package with a higher bandwidth and lower latency inter-chip communication having low power consumption and high energy efficiency.

### SUMMARY

One or more embodiments provide a method of manufacturing a semiconductor package with an optical bridge and an apparatus thereof.

One or more embodiments also provide a method of manufacturing a semiconductor package with a photonics integrated circuit connected to fiber through index matched glasses and an apparatus thereof.

One or more embodiments are directed to a process whereby the packaging method process flow is modified and an index matched glass substrate is used to allow for embedding of the optical bridge, completion of downstream process steps, and successful fiber attachment while maintaining the package structure integrity.

One or more embodiments are directed to a selective removal of the dielectric layer lithographically after embedding the optical bridge in order to expose the optical bridge, attachment of the index matched glass with index matched epoxy directly on top of the optical bridge, completion of the downstream process steps, and exposing the glass substrate surface through back-grinding operation.

One or more embodiments provide a scalable package that allows for on-package integration of EIC, memory, and PIC while enabling relatively high bandwidth intercommunication between these components by redistribution layers based routing and embedded photonics bridge, allows for fiber attach to the PIC using a glass spacer for the purpose of light coupling in a way that can be scalable, and allows for fiber coupling to PIC with topside grating structures embedded in the redistribution layers.

According to an aspect of one or more embodiments, there is provided a semiconductor package including a redistribution layer, a through mold via on a first surface of the redistribution layer, a photonics integrated circuit on the first surface of the redistribution layer, a first mold on the first surface of the redistribution layer, on a side surface of the through mold via, and on a side surface of the photonics integrated circuit, a first semiconductor device and a second semiconductor device on a second surface of the redistribution layer opposite to the first surface of the redistribution layer, a first glass protruding from the second surface of the redistribution layer and penetrating the redistribution layer from the first surface of the redistribution layer to the second surface of the redistribution layer, a second mold layer on the second surface of the redistribution layer, on a side surface of the first semiconductor device, on a side surface of the second semiconductor device, and on a side surface of the first glass, and a second glass on the first glass, the second glass being connected to fiber.

According to still another aspect of one or more embodiments, there is provided a method of manufacturing a semiconductor package, the method including providing a redistribution layer, providing a through mold via on a first surface of the redistribution layer, provided a photonics integrated circuit on the first surface of the redistribution layer, providing a first mold on the first surface of the redistribution layer, on a side surface of the through mold via, and on a side surface of the photonics integrated circuit, providing a first semiconductor device and a second semiconductor device on a second surface of the redistribution layer opposite to the first surface of the redistribution layer, providing a first glass to protrude from the second surface of the redistribution layer and penetrate the redistribution layer from the first surface of the redistribution layer to the second surface of the redistribution layer, providing a second mold layer on the second surface of the redistribution layer, on a side surface of the first semiconductor device, on a side surface of the second semiconductor device, and on a side surface of the first glass, and providing a second glass on the first glass, the second glass being connected to fiber.

According to another aspect of one or more embodiments, there is provided a semiconductor package including a redistribution layer including a redistribution insulating layer, a wiring pattern, and a vias, a through mold via on a first surface of the redistribution layer, the through mold via being connected to at least one of the wiring pattern and the vias, an under bump metallurgy layers on a first surface of the through mold via, a photonics integrated circuit on the first surface of the redistribution layer, a first mold on the first surface of the redistribution layer, on a side surface of the through mold via, and on a side surface of the photonics integrated circuit, a first semiconductor device and a second semiconductor device on a second surface of the redistribution layer opposite to the first surface of the redistribution layer, a first glass protruding from the second surface of the redistribution layer and penetrating the redistribution layer from the first surface of the redistribution layer to the second surface of the redistribution layer, a second mold layer on the second surface of the redistribution layer, on a side surface of the first semiconductor device, on a side surface of the second semiconductor device, and on a side surface of the first glass, and a second glass on the first glass, the second glass being connected to fiber.

### BRIEF DESCRIPTION OF DRAWINGS

The above and/or other aspects, features, and advantages of example embodiments of the disclosure will be more apparent from the following description taken in conjunction with the accompanying drawings, in which:
FIG. 1 illustrates a semiconductor package according to one or more embodiments;

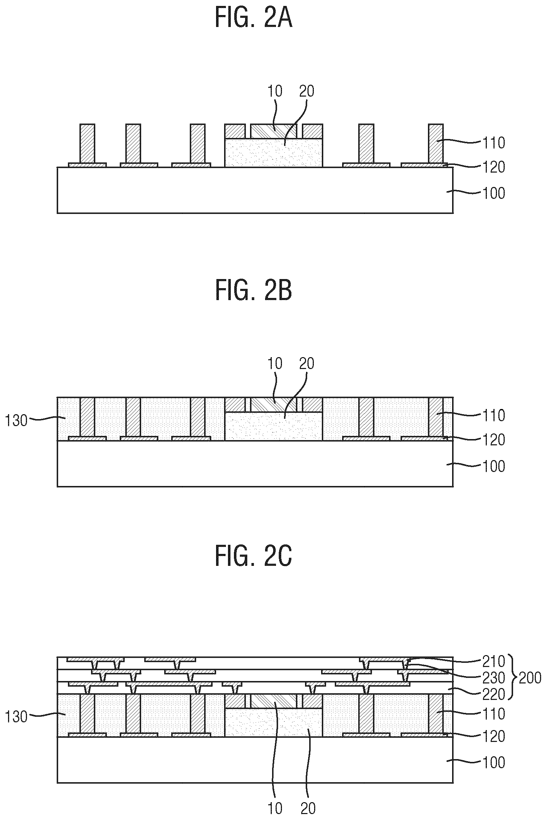

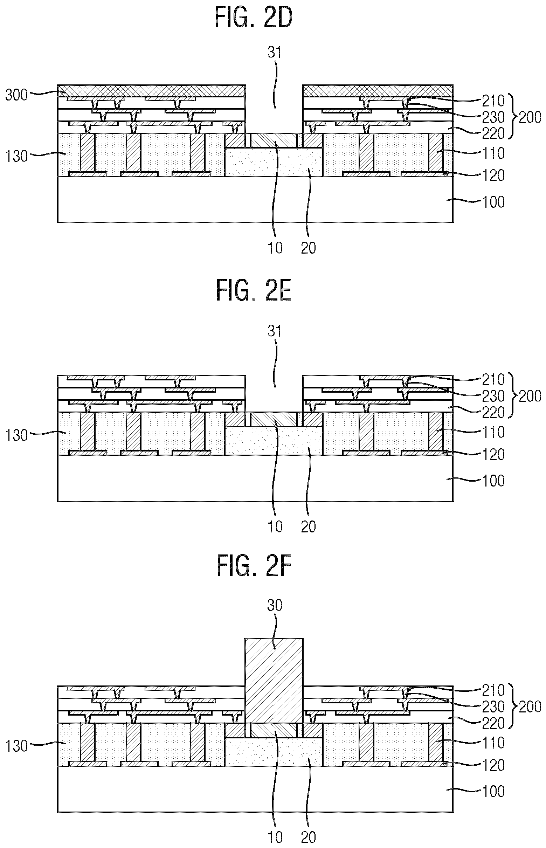

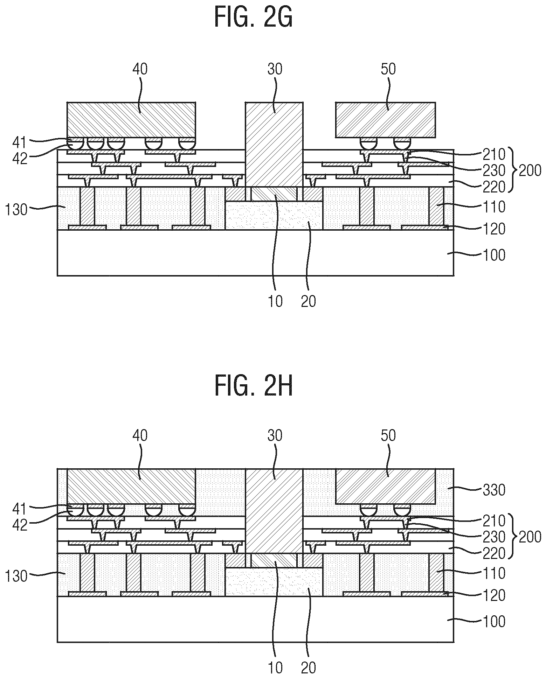

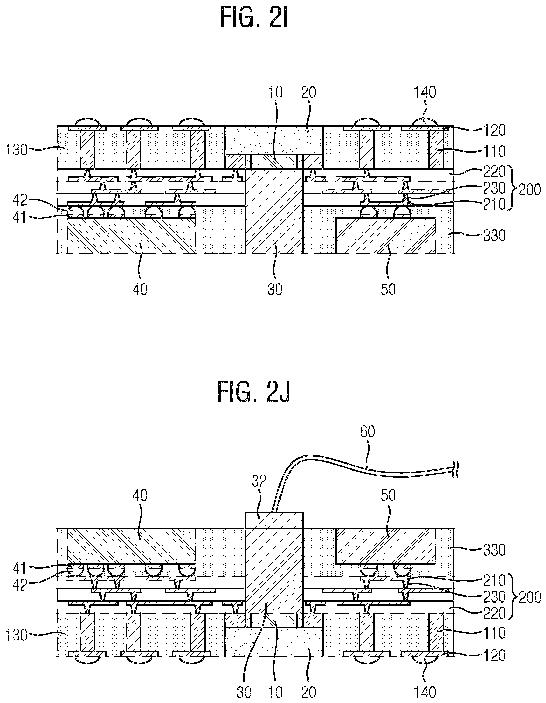

FIG. 2A illustrates cross-sectional view of providing a photonics IC and through-mold vias, FIG. 2B illustrates cross-sectional view of providing a first mold layer and a first index matched glass, FIG. 2C illustrates cross-sectional view of providing a redistribution layer, FIG. 2D illustrates cross-sectional view of providing a trench to expose the first index matched glass, FIG. 2E illustrates cross-sectional view of exposing the redistribution layer, FIG. 2F illustrates cross-sectional view of providing a second index matched glass, FIG. 2G illustrates cross-sectional view of providing a first semiconductor chip and a second semiconductor chip on the redistribution layer, FIG. 2H illustrates cross-sectional view of providing a second mold layer, FIG. 2I illustrates cross-sectional view of providing external connection terminals, and FIG. 2J illustrates cross-sectional view of providing a third index matched glass and a fiber in a semiconductor package according to one or more embodiments;
FIG. 3 illustrates a semiconductor package according to one or more other embodiments;

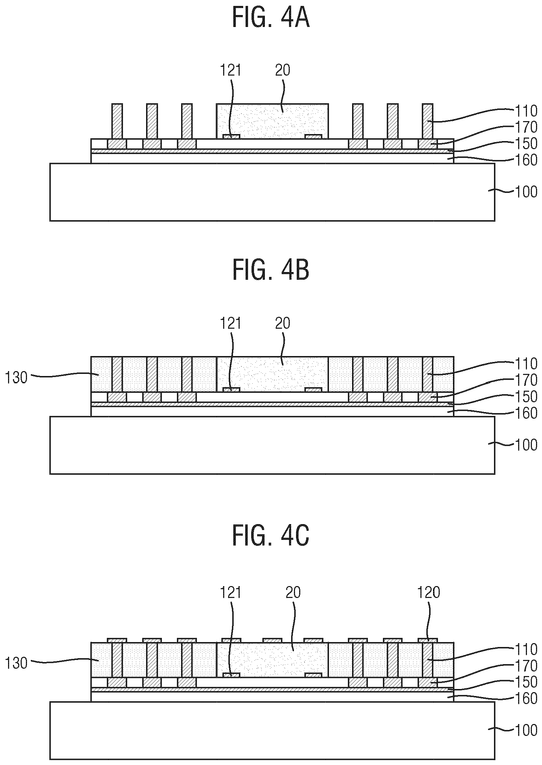

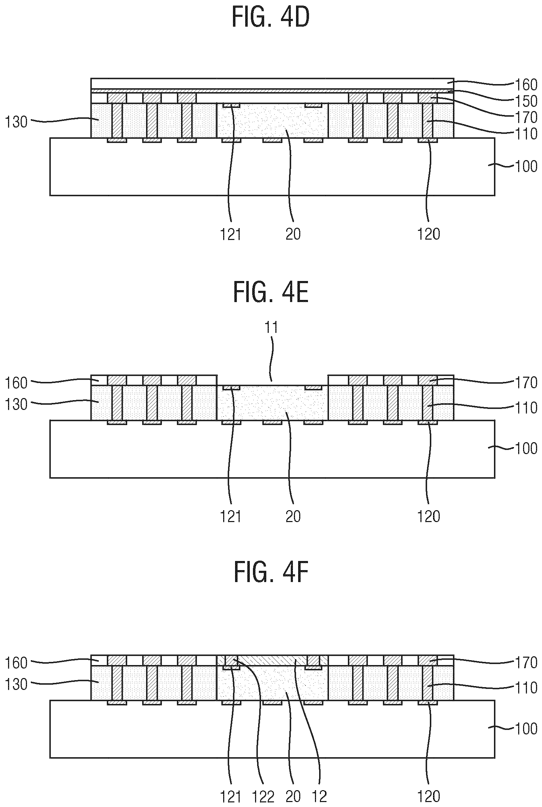

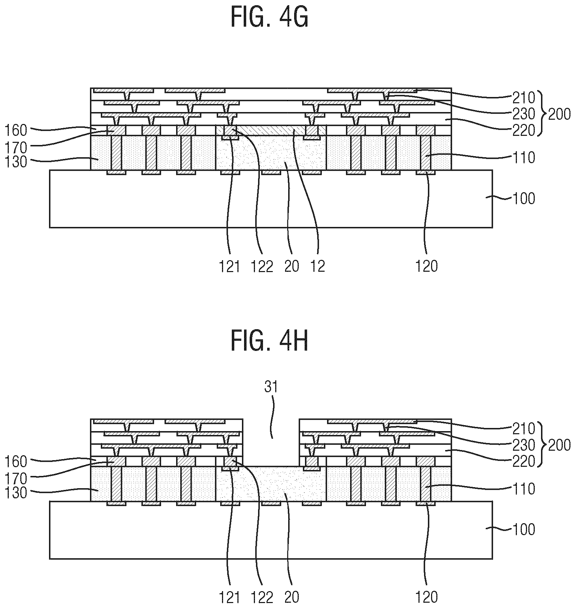

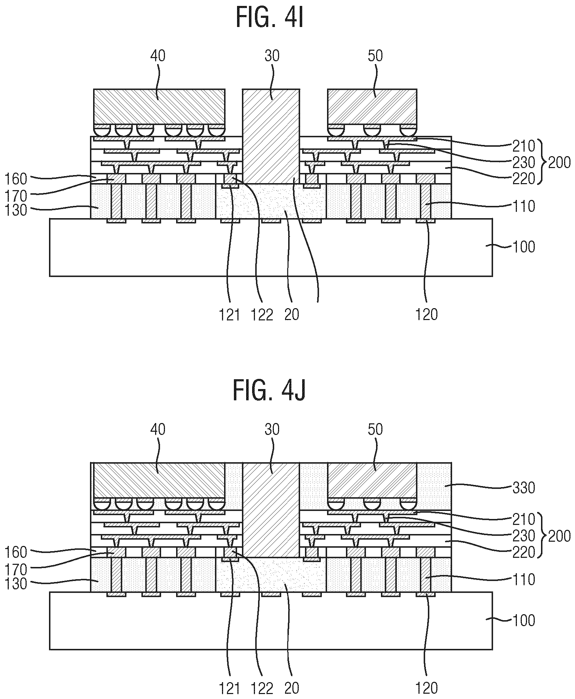

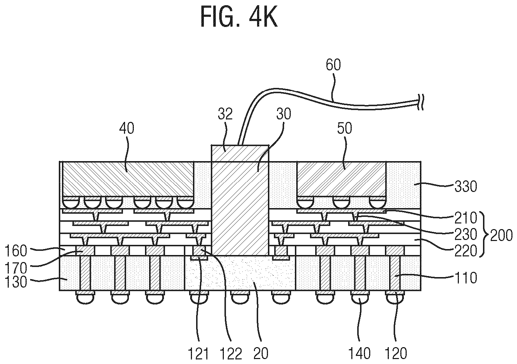

FIG. 4A illustrates cross-sectional view of providing through-mold vias and a photonics IC, FIG. 4B illustrates cross-sectional view providing a first mold layer, FIG. 4C providing under bump metallurgy (UBM) layers, FIG. 4D illustrates cross-sectional view of removing the carrier substrate and flipping the intermediate semiconductor package, FIG. 4E illustrates cross-sectional view of exposing the photonics IC, FIG. 4F illustrates cross-sectional view of providing a photoresist layer, FIG. 4G illustrates cross-sectional view of providing a redistribution layer, FIG. 4H illustrates cross-sectional view of providing a trench to expose the photonics IC, FIG. 4I illustrates cross-sectional view of providing a second index matched glass, a first semiconductor chip, and a second semiconductor chip, FIG. 4J illustrates cross-sectional view of providing a second mold layer, and FIG. 4K illustrates cross-sectional view providing external terminals in a semiconductor package according to one or more other embodiments;
FIG. 5 illustrates a flowchart of a method of manufacturing a semiconductor package according to one or more embodiments;
FIG. 6 illustrates a flowchart of a method of manufacturing a semiconductor package according to one or more other embodiments;
FIG. 7 illustrates a semiconductor package architecture that may incorporate the semiconductor packages according to one or more embodiments; and
FIG. 8 illustrates a schematic block diagram of an electronic system according to one or more embodiments.

### DETAILED DESCRIPTION

The embodiments described herein are examples or example embodiments, and thus, the present disclosure is not limited thereto, and may be realized in various other forms. Each of the embodiments provided in the following description is not excluded from being associated with one or more features of another example or another embodiment also provided herein or not provided herein but consistent with the present disclosure. For example, even if matters described in a specific example or embodiment are not described in a different example or embodiment thereto, the matters may be understood as being related to or combined with the different example or embodiment, unless otherwise mentioned in descriptions thereof.

In addition, it should be understood that all descriptions of principles, aspects, examples, and embodiments are intended to encompass structural and functional equivalents thereof. In addition, these equivalents should be understood as including not only currently well-known equivalents but also equivalents to be developed in the future, that is, all devices invented to perform the same functions regardless of the structures thereof.

It will be understood that when an element, component, layer, pattern, structure, region, or so on (hereinafter collectively "element") of a semiconductor device is referred to as being "over," "above," "on," "below," "under," "beneath," "connected to" or "coupled to" another element the semiconductor device, it can be directly over, above, on, below, under, beneath, connected or coupled to the other element or an intervening element(s) may be present. In contrast, when an element of a semiconductor device is referred to as being "directly over," "directly above," "directly on," "directly below," "directly under," "directly beneath," "directly connected to" or "directly coupled to" another element of the semiconductor device, there are no intervening elements present. Like numerals refer to like elements throughout this disclosure.

Spatially relative terms, such as "over," "above," "on," "upper," "below," "under," "beneath," "lower," "top," and "bottom," and the like, may be used herein for ease of description to describe one element's relationship to another element(s) as illustrated in the figures. It will be understood that the spatially relative terms are intended to encompass different orientations of a semiconductor device in use or operation in addition to the orientation depicted in the figures. For example, if the semiconductor device in the figures is turned over, elements described as "below" or "beneath" other elements would then be oriented "above" the other elements. Thus, the term "below" can encompass both an orientation of above and below. The semiconductor device may be otherwise oriented (rotated 90 degrees or at other orientations) and the spatially relative descriptors used herein interpreted accordingly.

As used herein, expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c. Herein, when a term "same" is used to compare a dimension of two or more elements, the term may cover a "substantially same" dimension.

It will be understood that, although the terms "first," "second," "third," "fourth," etc. may be used herein to describe various elements, these elements should not be limited by these terms. These terms are only used to distinguish one element from another element. Thus, a first element discussed below could be termed a second element without departing from the teachings of the present disclosure.

It will be also understood that, even if a certain step or operation of manufacturing an apparatus or structure is described later than another step or operation, the step or operation may be performed later than the other step or operation unless the other step or operation is described as being performed after the step or operation. It will be understood that any of the components or any combination of the components described herein may be used to perform one or more of the operations of the flowcharts. Further, all operations are example operations, and may include various additional steps.

Various embodiments are described herein with reference to cross-sectional illustrations that are schematic illustrations of the embodiments (and intermediate structures). As such, variations from the shapes of the illustrations as a result, for example, of manufacturing techniques and/or tolerances, are to be expected. Thus, the embodiments should not be construed as limited to the particular shapes of regions illustrated herein but are to include deviations in shapes that result, for example, from manufacturing. For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place. Thus, the regions illustrated in the figures are schematic in nature and their shapes are not intended to illustrate the actual shape of a region of a device and are not intended to limit the scope of the present disclosure. Further, in the drawings, the sizes and relative sizes of layers and regions may be exaggerated for clarity.

For the sake of brevity, general elements to semiconductor devices may or may not be described in detail herein.

An optical transceiver enables relatively high bandwidth data transport and communication using coherent light, which results in lower loss and attenuation as compared to, for example, copper wires. However, the optical transceiver has been primarily provided on the peripheral area of an integrated circuit (IC) package, which limits the optical transceiver's ability for data communication between the transceiver and the IC package hosting memory chips. Integration of these optical transceivers with a central processing unit (CPU), an application-specific integrated circuit (ASIC), and a memory chip on the IC package has been difficult due to the constraints optical transceiver imposes on the packaging and its manufacturing processes.

An on-package level integration of the optical transceiver with the IC package is required for a higher bandwidth, and lower latency inter-chip communication at lower power consumption and higher energy efficiency.

For an on-package integration higher bandwidth communication between a photonic IC (PIC) and the neighboring on-package components such as a CPU, a memory chip, etc., and an integration of the fiber attach onto the PIC for transportation of laser power and data in and out of package is needed.

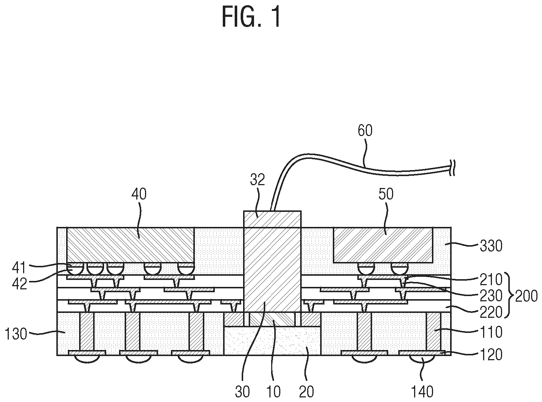

FIG. 1 illustrates a semiconductor package according to one or more embodiments.

Referring to FIG. 1, a semiconductor package 1 may include a redistribution layer 200, a first semiconductor chip 40 and a second semiconductor chip 50 that may be, for example, a logic chip, a memory chip, etc., a first index matched glass 10, a second index matched glass 30, a photonics integrated circuit (IC) 20, a first mold layer 130, a second mold layer 330, and a plurality of through-mold vias (TMVs) 110.

Herein, a direction parallel to a main surface (top surface or bottom surface) of the redistribution layer 200 may be referred to as a horizontal direction (X direction and/or Y direction), and a direction perpendicular and normal to the horizontal direction (X direction and/or Y direction) may be referred to as a vertical direction (Z direction).

The redistribution layer 200 may include a plurality of wiring patterns 210, a plurality of vias 230, and a redistribution insulating layer 220. The redistribution insulating layer 220 may include an insulating material, such as a photo-imageable dielectric resin prepared by combining epoxy resin and photoinitiators, and may further include photosensitive polyimide and/or inorganic fillers. The redistribution insulating layer 220 may include one or more redistribution insulating layers.

The plurality of wiring patterns 210 and the plurality of vias 230 may be provided as a conductive pattern to provide electrical connection between the first and second semiconductor chips 40 and 50 and structures external to the semiconductor package 1. The conductive pattern may be positioned on at least one of an upper surface and a lower surface of a redistribution insulating layer in an example in which the redistribution insulating layer 220 includes a plurality of redistribution insulating layers. The plurality of wiring patterns 210 may be provided to extend in the horizontal direction (X direction and/or Y direction) in the redistribution insulating layer 220. The plurality of vias 230 may penetrate a redistribution insulating layer in the vertical direction (Z direction), to contact and be electrically connected with some of the plurality of wiring patterns 210.

According to one or more embodiments, at least some of the plurality of wiring patterns 210 may be integrally provided together with some of the plurality of vias 230. For example, the plurality of wiring patterns 210 and the plurality of vias 230, which are in contact with a surface of the plurality of wiring patterns 210, may be integrally formed as a single structure.

According to one or more embodiments, the plurality of vias 230 may have any suitable shape including, for example, a tapered shape in which the horizontal widths of the plurality of vias 230 decrease in the vertical direction (Z direction) away from the first semiconductor chip 40 and the second semiconductor chip 50 which may facilitate the manufacturing process.

The plurality of wiring patterns 210 and the vias 230 may include, for example, metals such as copper (Cu), aluminum (Al), tungsten (W), titanium (Ti), tantalum (Ta), indium (In), molybdenum (Mo), manganese (Mn), cobalt (Co), tin (Sn), nickel (Ni), magnesium (Mg), rhenium (Re), beryllium (Be), gallium (Ga), ruthenium (Ru), and an alloy thereof but is not limited thereto.

The plurality of TMVs 110 may be provided on a first surface (bottom surface) of the redistribution layer 200. The plurality of TMVs 110 may include a conductive material including, for example, copper (Cu), aluminum (Al), silver (Ag), gold (Au), tungsten (W), titanium (Ti), and a combination thereof. Herein, a first surface and a second surface respectively represent a bottom or lower surface and a top or upper surface, respectively.

The plurality of TMVs 110 may have a first surface and a second surface spaced apart from each other in the vertical direction (Z direction). The plurality of TMVs 110 may be at least partially in contact with the plurality of vias 230 and wiring patterns 210. For example, the second surfaces of the TMVs 110 may be bonded and connected to the first surfaces of the plurality of vias 230, respectively.

A TMV 110 may have, for example, a cylindrical shape. The diameter of a TMV 110 in the horizontal direction (X or Y direction) may be constant along the vertical direction (Z direction). In another embodiment, the plurality of TMVs 110 may have a tapered shape having diameters that vary in the horizontal direction (X or Y direction) along the vertical direction (Z direction) depending on the manufacturing conditions.

The first mold layer 130 may be provided on the first surface of the redistribution layer 200 and surround side surfaces of the plurality of TMVs 110 to seal the semiconductor package 1 and protect the semiconductor package 1 from physical and chemical impacts. The first mold layer 130 may be an epoxy mold compound and may include, for example, epoxy mold resin with silicon fillers.

The semiconductor package 1 may also include a plurality of under bump metallurgy (UBM) layers 120 that are respectively in contact with first surfaces of the plurality of TMVs 110 that are exposed from the first mold layer 130. The UBM layer 120 may include a copper layer, a nickel layer, and a copper-nickel-tin intermetallic compound layer between the copper layer and the nickel layer. First surfaces of the UBM layers 120 may be substantially coplanar with a first surface of the first mold layer 130.

The plurality of UBM layers 120 may electrically and/or physically connect the plurality of TMVs 110 with other components of the semiconductor package 1 such as a plurality of external connection terminals 140 that connect the semiconductor package 1 to an element external to the semiconductor package 1 such as, for example, a printed circuit board (PCB). In addition, the plurality of UBM layers 120 may prevent a plurality of external connection terminals 140 from damage such as cracking due to thermal shock between the plurality of external connection terminals 140 and the redistribution layer 200, to thereby improve the reliability of the semiconductor package 1. The plurality of UBM layers 120 may include a conductive material, for example, copper (Cu), aluminum (Al), silver (Ag), gold (Au), tungsten (W), titanium (Ti), and a combination thereof.

The plurality of external connection terminals 140 may be provided on the first surfaces of the plurality of UBM layers 120, respectively. The plurality of external connection terminals 140 may be configured to connect the redistribution layer 200 and an external device electrically and/or physically. According to one or more embodiments, the plurality of external connection terminals 140 may include, for example, a solder ball, a conductive bump, and a flip-chip connection structure having a grid array such as a pin grid array, a ball grid array, and a land grid array. The plurality of external connection terminals 140 may be electrically connected to the plurality of UBM layers 120 and may be electrically connected to the external device such as a module substrate, a system board, and a printed circuit board.

The photonics IC 20 may be at least laterally surrounded by the first mold layer 130. A first surface of the photonics IC 20 may be substantially coplanar with the first surfaces of the plurality of UBM layers 120 and the first surface of the first mold layer 130. A second surface of the photonics IC 20 may contact some of the plurality of TMVs 110 which are connected to the plurality of wiring patterns 210 included in the redistribution layer 200. The first index matched glass 10 may be provided on a second surface of the photonics IC 20. A second surface of the first index matched glass 10 may be substantially coplanar with a second surface of the first mold layer 130 and second surfaces of the plurality of TMVs 110.

The first semiconductor chip 40 and the second semiconductor chip 50 may be provided on a second surface of the redistribution layer 200 and be electrically connected to structures external to the semiconductor package 1 through the redistribution layer 200. A plurality of connection pads 41 and connection structures 42 may be provided on first surfaces of the first semiconductor chip 40 and the second semiconductor chip 50. Some of the plurality of connection pads 41 and connection structures 42 may be provided between the first surface of the first semiconductor chip 40 and the second surface of the redistribution layer 200, and connect the first semiconductor chip 40 to some of the wiring patterns 210 of the redistribution layer 200. Similarly, some of the plurality of connection pads 41 and connection structures 42 may be provided between the first surface of the second semiconductor chip 50 and the second surface of the redistribution layer 200, and connect the second semiconductor chip 50 to some of the wiring patterns 210 of the redistribution layer 200. The first semiconductor chip 40 and the second semiconductor chip 50 may be electrically connected to the redistribution layer 200 through the plurality of connection pads 41 and the plurality of connection structures 42, respectively.

For example, the first semiconductor chip 40 may be an application-specific integrated circuit (ASIC) chip and the second semiconductor chip 50 may be a high bandwidth memory (HBM) chip. However, embodiments are not limited thereto. As another example, the first semiconductor chip 40 and the second semiconductor chip 50 may each be a system-on-chip (SOC), a memory chip such as a dynamic random access memory (DRAM) chip and a NAND chip, or a logic chip such as a CPU, a graphical processing unit (GPU), and a field programmable gate array (FPGA) chip, etc.

The second mold layer 330 may be provided on the second surface of the redistribution layer 200 and surround the first semiconductor chip 40, the second semiconductor chip 50, the plurality of connection pads 41 and the plurality of connection structures 42 to seal the semiconductor package 1 and protect the semiconductor package 1 from physical and chemical impacts. The second mold layer 330 be an epoxy mold compound and may include, for example, epoxy mold resin.

A second index matched glass 30 may be provided between the first semiconductor chip 40 and the second semiconductor chip 50, in the second mold layer 330. The second index matched glass 30 may penetrate through the redistribution layer 200 to a level of the second surface of the first index matched glass 10, and may contact the second surface of the first index matched glass 10. The second index matched glass 30 may protrude away from the second surface of the redistribution layer 200 in the vertical direction (Z direction). The second mold layer 330 may surround side surfaces of the second index matched glass 30. A second surface of the second index matched glass 30 may be substantially coplanar with a second surface of the first semiconductor chip 40, a second surface of the second semiconductor chip 50, and a second surface of the second mold layer 330.

The semiconductor package 1 may also include a third index matched glass 32 provided to contact the second surface of the second index matched glass 30 and connected to fiber 60. For example, a refractive index of the first index matched glass 10, a refractive index of the second index matched glass 30, and a refractive index of the third index matched glass 32 may be the same to prevent light from bending when the light is transmitted from the fiber 60 to the photonics IC 20 through the third index matched glass 32, the second index matched glass 30, and the first index matched glass 10.

Based on the on-package level integration of the photonics IC 20 being connected to fiber 60 through the first index matched glass 10, the second index matched glass 30, and the third index matched glass 32, the semiconductor package 1 may enable a higher bandwidth and lower latency inter-chip communication having a lower power consumption and higher energy efficiency.

FIGS. 2A through 2J are cross-sectional views illustrating an intermediate semiconductor package after respective steps of a method of manufacturing a semiconductor package according to one or more embodiments.

The semiconductor package manufactured through the method described herebelow may be the same as or correspond to the semiconductor package 1 shown in FIG. 1, and thus, duplicate descriptions thereof may be omitted herein and the same reference numerals used in the above description of the semiconductor package 1 may be used herebelow.

Referring to FIG. 2A, UBM layers 120 are provided on a carrier substrate 100. A photonics IC 20 is provided on the carrier substrate 100. A plurality of TMVs 110 are provided on second surfaces of the respective UBM layers on the carrier substrate 100 to be adjacent to the photonics IC 20. Some of the TMVs 110 are provided on a second surface of the photonics IC 20. A first index matched glass 10 is provided on the second surface of the photonics IC 20 between the TMVs 110 provided on the photonics IC 20. Second surfaces of the plurality of TMVs 110 and a second surface of the first index matched glass 10 may be substantially coplanar.

The plurality of TMVs 110 may include a conductive material including, for example, copper (Cu), aluminum (Al), silver (Ag), gold (Au), tungsten (W), titanium (Ti), and a combination thereof. The UBM layers 120 may include a conductive material, for example, copper (Cu), aluminum (Al), silver (Ag), gold (Au), tungsten (W), titanium (Ti), and a combination thereof.

Referring to FIG. 2B, a first mold layer 130 may be provided on the carrier substrate 100 to surround side surfaces of the plurality of TMVs 110, the first index matched glass 10 and the photonics IC 20. A second surface of the first mold layer 130 may be substantially coplanar with the second surfaces of the plurality of TMVs 110 and the second surface of the first index matched glass 10. For example, the first mold layer 130 may include epoxy resin with silicon fillers.

Referring to FIG. 2C, a redistribution layer 200 may be provided on the second surfaces of the plurality of TMVs 110, a second surface of the first mold layer 130, and the second surface of the first index matched glass 10. The redistribution layer 200 may include a plurality of wiring patterns 210, a plurality of vias 230, and a redistribution insulating layer 220 surrounding the wiring patterns 210 and the vias 230. The redistribution insulating layer 220 may include an insulating material, such as a photo-imageable dielectric resin, and may further include photosensitive polyimide and/or inorganic fillers. The redistribution insulating layer 220 may include one or more redistribution insulating layers.

The plurality of wiring patterns 210 and the plurality of vias 230 may be provided as a conductive pattern, and the conductive pattern may be positioned on at least one of a first surface and a second surface of a redistribution insulating layer in an example in which the redistribution insulating layer 220 includes a plurality of redistribution insulating layers. The plurality of wiring patterns 210 may be provided to extend in a horizontal direction (X direction and/or Y direction) in the redistribution insulating layer 220. The plurality of vias 230 may penetrate a redistribution insulating layer in a vertical direction (Z direction), to contact and be electrically connected with some of the plurality of wiring patterns 210.

According to one or more embodiments, the plurality of vias 230 may have a tapered shape in which the horizontal widths of the plurality of vias 230 decrease in the vertical direction (Z direction) away from the first semiconductor chip 40 and the second semiconductor chip 50.

The plurality of wiring patterns 210 and the plurality of vias 230 may include, for example, metals such as copper (Cu), aluminum (Al), tungsten (W), titanium (Ti), tantalum (Ta), indium (In), molybdenum (Mo), manganese (Mn), cobalt (Co), tin (Sn), nickel (Ni), magnesium (Mg), rhenium (Re), beryllium (Be), gallium (Ga), ruthenium (Ru), and an alloy thereof but is not limited thereto.

Referring to FIG. 2D, a resist layer 300 may be applied on a second surface of the redistribution layer 200, and a trench 31 may be, for example, wet etched through a lithography process to a level of the first index matched glass 10 in the vertical direction (Z direction) to expose the second surface of the first index matched glass 10.

Referring to FIG. 2E, the resist layer 300 may be removed through, for example, a descum process to expose the second surface of the redistribution layer 200.

Referring to FIG. 2F, a second index matched glass 30 may be provided in the trench 31 to protrude from the second surface of the redistribution layer 200 in the vertical direction (Z direction). For example, a second surface of the second index matched glass 30 may be formed to be higher than the second surface of the redistribution layer 200 in the vertical direction (Z direction).

Referring to FIG. 2G, a first semiconductor chip 40 and a second semiconductor chip 50 may be provided on the second surface of the redistribution layer 200. Further, a plurality of connection pads 41 and connection structures 42 may be provided on first surfaces of the first semiconductor chip 40 and the second semiconductor chip 50. Some of the plurality of connection pads 41 and connection structures 42 may be provided between a first surface of the first semiconductor chip 40 and the plurality of wiring patterns 210, and connect the first semiconductor chip 40 to the redistribution layer 200. Similarly, some of the plurality of connection pads 41 and connection structures 42 may be provided between a first surface of the second semiconductor chip 50 and the plurality of wiring patterns 210, and connect the second semiconductor chip 50 to the redistribution layer 200.

For example, the first semiconductor chip 40 may be an ASIC chip and the second semiconductor chip 50 may be an HBM chip. However, embodiments are not limited thereto.

Referring to FIG. 2H, a second mold layer 330 may be provided on the second surface of the redistribution layer 200 and surround the first semiconductor chip 40, the second semiconductor chip 50, the plurality of connection pads 41 and the plurality of connection structures 42. The second mold layer 330 be an epoxy mold compound and may include, for example, epoxy mold resin with silicon fillers. A second surface of the first semiconductor chip 40, a second surface of the second semiconductor chip 50, and a second surface of the second mold layer 330 may be grinded to be substantially coplanar.

Referring to FIG. 2I, the carrier substrate 100 may be removed and the intermediate semiconductor package obtained in the previous step (FIG. 2H) may be flipped upside down. A plurality of external connection terminals 140 may be provided on first surfaces of the UBM layers 120. The external connection terminals 140 may be configured to connect the redistribution layer 200 and an external device electrically and physically. According to one or more embodiments, the external connection terminals 140 may include, for example, a solder ball, a conductive bump, and a flip-chip connection structure having a grid array such as a pin grid array, a ball grid array, and a land grid array. The external connection terminals 140 may be electrically connected to the UBM layers 120 and may be electrically connected to the external device such as a module substrate, a system board, and a printed circuit board.

Referring to FIG. 2J, the intermediate semiconductor package obtained in the previous step (FIG. 2I) may be flipped upside down, and a third index matched glass 32 with a fiber 60 attached thereto may be provided on the second surface of the second index matched glass 30. Here, refractive indexes of the first index matched glass 10, the second index matched glass 30, and the third index matched glass 32 may be the same to prevent light from bending when the light is transmitted from the fiber 60 to the photonics IC 20 through the third index matched glass 32, the second index matched glass 30, and the first index matched glass 10.

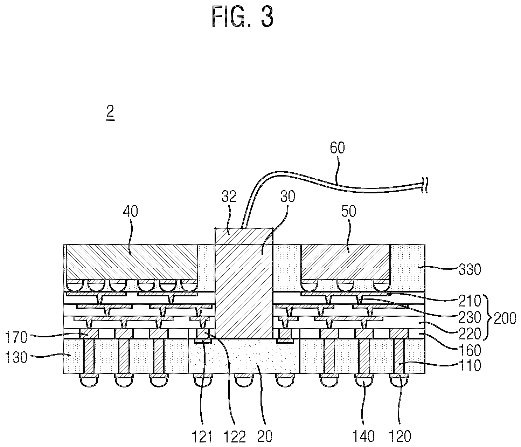

FIG. 3 illustrates a semiconductor package according to one or more other embodiments.

The semiconductor package shown in FIG. 3 may include a plurality of structural elements which may be the same as or similar to those shown in FIG. 1. These structural elements may be described herebelow using the same reference numbers shown in FIG. 1 for description convenience.

Referring to FIG. 3, a semiconductor package 2 may include a redistribution layer 200, a first semiconductor chip 40, a second semiconductor chip 50, a second index matched glass 30, a photonics IC 20, a first mold layer 130, a second mold layer 330, and a plurality of TMVs 110.

The redistribution layer 200 may include a plurality of wiring patterns 210, a plurality of vias 230, and a redistribution insulating layer 220. The redistribution insulating layer 220 may include an insulating material, such as a photo-imageable dielectric resin prepared by combining epoxy resin and photoinitiators, and may further include photosensitive polyimide and/or inorganic fillers. The redistribution insulating layer 220 may include one or more redistribution insulating layers.

The plurality of wiring patterns 210 and the plurality of vias 230 may be provided as a conductive pattern to provide electrical connection between the first and second semiconductor chips 40 and 50 and structures external to the semiconductor package 1. The conductive pattern may be positioned on at least one of a first surface and a second surface of a redistribution insulating layer in an example in which the redistribution insulating layer 220 includes a plurality of redistribution insulating layers. The plurality of wiring patterns 210 may be provided to extend in the horizontal direction (X direction and/or Y direction) in the redistribution insulating layer 220. The plurality of vias 230 may penetrate a redistribution insulating layer in the vertical direction (Z direction), to contact and be electrically connected with some of the plurality of wiring patterns 210.

According to one or more embodiments, at least some of the plurality of wiring patterns 210 may be integrally provided together with some of the plurality of vias 230. For example, the plurality of wiring patterns 210 and the plurality of vias 230, which are in contact with a surface of the plurality of wiring patterns 210, may be integrally formed as a single structure.

According to one or more embodiments, the plurality of vias 230 may have any suitable shape including, for example, a tapered shape in which the horizontal widths of the plurality of vias 230 decrease in the vertical direction (Z direction) away from the first semiconductor chip 40 and the second semiconductor chip 50 which may facilitate the manufacturing process.

The plurality of wiring patterns 210 and the plurality of vias 230 may include, for example, metals such as copper (Cu), aluminum (Al), tungsten (W), titanium (Ti), tantalum (Ta), indium (In), molybdenum (Mo), manganese (Mn), cobalt (Co), tin (Sn), nickel (Ni), magnesium (Mg), rhenium (Re), beryllium (Be), gallium (Ga), ruthenium (Ru), and an alloy thereof but is not limited thereto.

A dielectric layer 160 may be provided on a first surface of the redistribution layer 200. The dielectric layer 160 may include conductive plates 170 that are electrically and/or physically connected to the plurality of vias 230, respectively.

The plurality of TMVs 110 may be provided on a first surface of the dielectric layer 160. The plurality of TMVs 110 may include a conductive material including, for example, copper (Cu), aluminum (Al), silver (Ag), gold (Au), tungsten (W), titanium (Ti), and a combination thereof.

The plurality of TMVs 110 may have a first surface and a second surface spaced apart from each other in the vertical direction (Z direction). The plurality of TMVs 110 may be at least partially in contact with the plurality of vias 230 and wiring patterns 210 exposed on the first surface of the redistribution layer 200 through the plurality of conductive plates 170. For example, the second surfaces of the TMVs 110 may be bonded and connected to the first surfaces of the plurality of conductive plates 170, respectively.

A TMV 110 may have, for example, a cylindrical shape. The diameter of a TMV 110 in the horizontal direction (X or Y direction) may be constant along the vertical direction (Z direction). In another embodiment, the plurality of TMVs 110 may have a tapered shape having diameters that vary in the horizontal direction (X or Y direction) along the vertical direction (Z direction) depending on the manufacturing conditions.

The first mold layer 130 may be provided on the first surface of the redistribution layer 200 and surround side surfaces of the plurality of TMVs 110 to seal the semiconductor package 2 and protect the semiconductor package 2 from physical and chemical impacts. The first mold layer 130 may be an epoxy mold compound and may include, for example, epoxy mold resin with silicon fillers.

The semiconductor package 2 may also include a plurality of UBM layers 120 that are respectively in contact with the first surfaces of the plurality of TMVs 110 that are exposed from the first mold layer 130. The plurality of UBM layers 120 may electrically and/or physically connect the plurality of TMVs 110 with other components of the semiconductor package 2 such as a plurality of external connection terminals 140 that connect the semiconductor package 1 to an element external to the semiconductor package 2 such as, for example, a printed circuit board (PCB). In addition, the plurality of UBM layers 120 may prevent a plurality of external connection terminals 140 from damage such as cracking due to thermal shock between the plurality of external connection terminals 140 and the redistribution layer 200. The plurality of UBM layers 120 may include a conductive material, for example, copper (Cu), aluminum (Al), silver (Ag), gold (Au), tungsten (W), titanium (Ti), and a combination thereof.

The plurality of external connection terminals 140 may be provided on the first surfaces of the plurality of UBM layers 120, respectively. The plurality of external connection terminals 140 may be configured to connect the redistribution layer 200 and an external device electrically and/or physically. According to one or more embodiments, the plurality of external connection terminals 140 may include, for example, a solder ball, a conductive bump, and a flip-chip connection structure having a grid array such as a pin grid array, a ball grid array, and a land grid array. The plurality of external connection terminals 140 may be electrically connected to the plurality of UBM layers 120 and may be electrically connected to the external device such as a module substrate, a system board, and a printed circuit board.

A photonics IC 20 may be at least laterally surrounded by the first mold layer 130. A first surface of the photonics IC 20 may be substantially coplanar with second surfaces of the UBM layers 120 and a first surface of the first mold layer 130. A second surface of the photonics IC 20 may contact some of the plurality of TMVs 110 which are connected to the plurality of wiring patterns 210 included in the redistribution layer 200. The second surface of the photonics IC 20 may be substantially coplanar with the second surfaces of the plurality of TMVs 110 and the second surface of the first mold layer 130.

A plurality of connection plates 122 may electrically connect the photonics IC 20 to the redistribution layer 200, for example, the plurality of vias 230 in the redistribution layer 200. The plurality of connection plates 122 may be connected to the photonics IC 20 through a plurality of connection pads 121 provided on a second surface of the photonics IC 20. Second surfaces of the connection pads 121 may be coplanar with the second surface of the photonics IC 20. The plurality of connection plates 122 may include a conductive material, for example, copper (Cu), aluminum (Al), silver (Ag), gold (Au), tungsten (W), titanium (Ti), and a combination thereof. The plurality of connection plates 122 may be surrounded by the dielectric layer 160.

The first semiconductor chip 40 and the second semiconductor chip 50 may be provided on a second surface of the redistribution layer 200 and be electrically connected to structures external to the semiconductor package 2 through the redistribution layer 200. A plurality of connection pads 41 and connection structures 42 may be provided on first surfaces of the first semiconductor chip 40 and the second semiconductor chip 50. Some of the plurality of connection pads 41 and a plurality of connection structures 42 may be provided between the second surface of the redistribution layer 200 and a first surface of the first semiconductor chip 40, and connect the first semiconductor chip 40 to some of the wiring patterns 210 of the redistribution layer 200. Similarly, some of the plurality of connection pads 41 and the plurality of connection structures 42 may be provided between the second surface of the redistribution layer 200 and a first surface of the second semiconductor chip 50, and connect the second semiconductor chip 50 to some of the wiring patterns 210 of the redistribution layer 200. The first semiconductor chip 40 and the second semiconductor chip 50 may be electrically connected to the redistribution layer 200 through the plurality of connection pads 41 and the plurality of connection structures 42, respectively.

For example, the first semiconductor chip 40 may be an ASIC chip and the second semiconductor chip 50 may be an HBM chip. However, embodiments are not limited thereto.

The second mold layer 330 may be provided on the second surface of the redistribution layer 200 and surround the first semiconductor chip 40, the second semiconductor chip 50, the plurality of connection pads 41 and the plurality of connection structures 42. The second mold layer 330 be an epoxy mold compound and may include, for example, epoxy mold resin with silicon fillers.

A second index matched glass 30 may be provided between the first semiconductor chip 40 and the second semiconductor chip 50, in the second mold layer 330. The second index matched glass 30 may penetrate through the redistribution layer 200 and the dielectric layer 160 to a level of the second surface of the photonics IC 20. A first surface of the second index matched glass 30 may contact the second surface of the photonics IC 20. The second mold layer 330 may surround side surfaces of the second index matched glass 30. A second surface of the second index matched glass 30 may be substantially coplanar with a second surface of the first semiconductor chip 40, a second surface of the second semiconductor chip 50, and a second surface of the second mold layer 330.

The semiconductor package 2 may also include a third index matched glass 32 provided on the second surface of the second index matched glass 30 and connected to fiber 60. For example, the index of the second index matched glass 30 and the third index matched glass 32 may be the same to prevent light from bending when the light is transmitted from the fiber 60 to the photonics IC 20 through the third index matched glass 32 and the second index matched glass 30.

Based on the on-package level integration of the photonics IC 20 connected to fiber 60 through the second index matched glass 30 and the third index matched glass 32, the semiconductor package 2 may enable a higher bandwidth and lower latency inter-chip communication having a lower power consumption and higher energy efficiency.

FIGS. 4A through 4k are cross-sectional views illustrating an intermediate semiconductor package after respective steps of a method of manufacturing a semiconductor package according to one or more other embodiments.

The semiconductor package manufactured through the method described herebelow may be the same as or correspond to the semiconductor package 2 shown in FIG. 3, and thus, duplicate descriptions thereof may be omitted herein and the same reference numerals used in the above description of the semiconductor package 2 may be used herebelow

Referring to FIG. 4A, a dielectric layer 160 may be provided on a carrier substrate 100. The dielectric 160 may include a conductive layer 150 and a plurality of conductive plates 170 provided on a first surface of the conductive layer 150. A first surface of the dielectric layer 160 may be substantially coplanar with first surfaces of the conductive plates 170. A plurality of TMVs 110 may be provided on a first surface of the dielectric layer 160 and respectively contact the first surfaces of the conductive plates 170.

A photonics IC 20 is provided on the first surface of the dielectric layer 160 to be adjacent to the plurality of TMVs 110. A plurality of connection pads 121 may be provided on a second surface of the photonics IC 20. Second surfaces of the connection pads 121 may be coplanar with the second surface of the photonics IC 20.

The plurality of TMVs 110, the plurality of conductive plates 170, and the conductive layer 150 may include a conductive material including, for example, copper (Cu), aluminum (Al), silver (Ag), gold (Au), tungsten (W), titanium (Ti), and a combination thereof.

Referring to FIG. 4B, a first mold layer 130 may be provided on the dielectric layer 160 to surround side surfaces of the plurality of TMVs 110 and the photonics IC 20. A first surface of the first mold layer 130 may be substantially coplanar with the first surfaces of the plurality of TMVs 110 and the first surface of the photonics IC 20. For example, the first mold layer 130 may include epoxy resin with silicon fillers.

Referring to FIG. 4C, a plurality of UBM layers 120 may be provided on the TMVs 110 and the photonics IC 20. The plurality of UBM layers 120 may be contact the first surfaces of the plurality of TMVs 110 and the photonics IC 20. The plurality of UBM layers 120 may include a conductive material, for example, copper (Cu), aluminum (Al), silver (Ag), gold (Au), tungsten (W), titanium (Ti), and a combination thereof.

Referring to FIG. 4D, the carrier substrate 100 may be detached, the intermediate semiconductor package obtained in the previous step (FIG. 4C) may be flipped upside down, and reattached to the carrier substrate 100.

Here, the carrier substrate 100 may be reattached on an opposite side including the first surface of the first mold layer 130 and first surfaces of the UBM layer 120.

Referring to FIG. 4E, the dielectric layer 160 and the conductive layer 150 may be etched by photo-imageable dielectric lithography to form a trench 11 and expose the second surfaces of the photonics IC 20 and the connection pads 121.

By the etching operation in this step, a portion of the dielectric layer 160 on the second surface of the conductive layer 150 and the conductive layer 150 may be entirely removed, and part of the other portion of the dielectric layer 160 overlapping the photonics IC 20 may be removed to expose the second surfaces of the photonics IC 20 and the connection pads 121.

Referring to FIG. 4F, a photoresist layer 12 including a photoresist material may be formed in the trench 11. Further, a plurality of connection plates 122 may be provided on the second surfaces of the plurality of connection pads 121 by patterning the photoresist layer 12, such that second surfaces of the plurality of connection plates 122 are substantially coplanar with the second surfaces of the plurality of conductive plates 170 and the second surface of the dielectric layer 160.

Referring to FIG. 4G, the photoresist layer 12 may be removed through, for example, a descum process to expose the second surface of the photonics IC 20. A redistribution layer 200 may be provided on the second surfaces of the dielectric layers 160 in which the plurality of conductive plates 170 are provided and on the second surface of the photonics IC 20 to fill spaces formed by removing the photoresist layer 12. The redistribution layer 200 may include a plurality of wiring patterns 210, a plurality of vias 230, and a redistribution insulating layer 220 surrounding the wiring patterns 210 and the vias 230. The redistribution insulating layer 220 may include an insulating material, such as a photo-imageable dielectric resin, and may further include photosensitive polyimide and/or inorganic fillers. The redistribution insulating layer 220 may include one or more redistribution insulating layers.

The plurality of wiring patterns 210 and the plurality of vias 230 may be provided as a conductive pattern, and the conductive pattern may be positioned on at least one of a first surface and a second surface of a redistribution insulating layer in an example in which the redistribution insulating layer 220 includes a plurality of redistribution insulating layers. The plurality of wiring patterns 210 may be provided to extend in a horizontal direction (X direction and/or Y direction) in the redistribution insulating layer 220. The plurality of vias 230 may penetrate a redistribution insulating layer in a vertical direction (Z direction), to contact and be electrically connected with some of the plurality of wiring patterns 210. The lowermost vias 230 may contact the second surfaces of the plurality of conductive plates 170 and the plurality of connection plates 122.

According to one or more embodiments, the plurality of vias 230 may have a tapered shape in which the horizontal widths of the plurality of vias 230 decrease in the vertical direction (Z direction) away from the first semiconductor chip 40 and the second semiconductor chip 50.

The plurality of wiring patterns 210 and the plurality of vias 230 may include, for example, metals such as copper (Cu), aluminum (Al), tungsten (W), titanium (Ti), tantalum (Ta), indium (In), molybdenum (Mo), manganese (Mn), cobalt (Co), tin (Sn), nickel (Ni), magnesium (Mg), rhenium (Re), beryllium (Be), gallium (Ga), ruthenium (Ru), and an alloy thereof but is not limited thereto.

Referring to FIG. 4H, a trench 31 may be formed in the redistribution layer 200 by a lithography process, for example, wet etching, to a level of the second surface of the photonics IC 20 in the vertical direction (Z direction) to expose the photonics IC 20.

Referring to FIG. 4I, a second index matched glass 30 may be provided in the trench 31 to contact the second surface of the photonics IC 20 and to protrude from the second surface of the redistribution layer 200 in the vertical direction (Z direction). For example, a second surface of the second index matched glass 30 may be formed to be higher than the second surface of the redistribution layer 200 in the vertical direction (Z direction).

A first semiconductor chip 40 and a second semiconductor chip 50 may be provided on the second surface of the redistribution layer 200 and be electrically connected to structures external to the semiconductor package through the redistribution layer 200. Some of a plurality of connection pads 41 and connection structures 42 may be provided between a first surface of the first semiconductor chip 40 and the plurality of wiring patterns 210, and connect the first semiconductor chip 40 to the redistribution layer 200. Similarly, some of the plurality of connection pads 41 and connection structures 42 may be provided between a first surface of the second semiconductor chip 50 and the plurality of wiring patterns 210, and connect the second semiconductor chip 50 to the redistribution layer 200.

For example, the first semiconductor chip 40 may be an application-specific integrated circuit (ASIC) chip and the second semiconductor chip 50 may be a high bandwidth memory (HBM) chip. However, embodiments are not limited thereto. For example, the first semiconductor chip 40 and the second semiconductor chip 50 may be an SOC, a memory chip such as a DRAM chip and a NAND chip, or a logic chip such as a CPU, a GPU, and an FPGA chip, etc.

Referring to FIG. 4J, a second mold layer 330 may be provided on the second surface of the redistribution layer 200 and surround the first semiconductor chip 40, the second semiconductor chip 50, the plurality of connection pads 41 and the plurality of connection structures 42 to seal the semiconductor package and protect the semiconductor package from physical and chemical impacts. The second mold layer 330 be an epoxy mold compound and may include, for example, epoxy mold resin with silicon fillers. A second surface of the first semiconductor chip 40, a second surface of the second semiconductor chip 50, and a second surface of the second mold layer 330 may be grinded to be substantially coplanar.

Referring to FIG. 4K, the carrier substrate 100 may be removed. A plurality of external connection terminals 140 may be provided on the first surfaces of the plurality of UBM layers 120. The plurality of external connection terminals 140 may be configured to connect the redistribution layer 200 and an external device electrically and physically. According to one or more embodiments, the plurality of external connection terminals 140 may include, for example, a solder ball, a conductive bump, and a flip-chip connection structure having a grid array such as a pin grid array, a ball grid array, and a land grid array. The plurality of external connection terminals 140 may be electrically connected to the plurality of UBM layers 120 and may be electrically connected to the external device such as a module substrate, a system board, and a printed circuit board. Further, a third index matched glass 32 with a fiber 60 attached thereto may be provided on the first surface of the second index matched glass 30. Here, refractive indexes of the second index matched glass 30 and the third index matched glass 32 may be the same to prevent light from bending when the light is transmitted from the fiber 60 to the photonics IC 20 through the third index matched glass 32, the second index matched glass 30, and the first index matched glass 10.

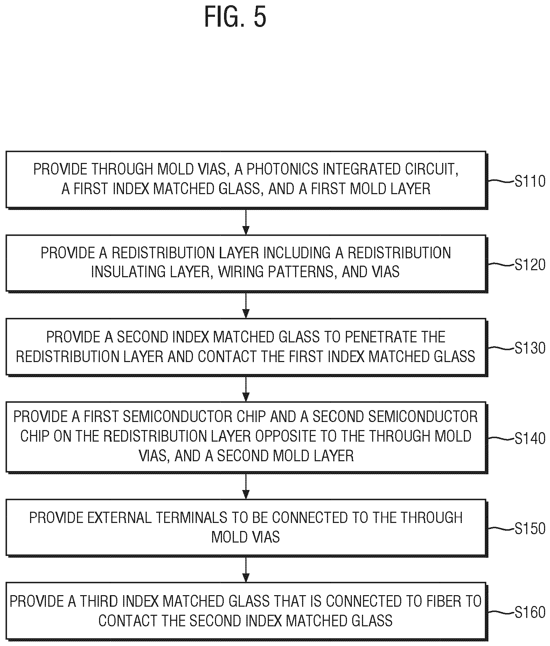

FIG. 5 illustrates a flowchart of manufacturing a semiconductor package according to one or more embodiments. The semiconductor device manufactured through the flowchart described herebelow may the same as or correspond to the semiconductor package 1 shown in FIG. 1.

In operation S 110, a photonics IC and a plurality of TMVs are provided on a carrier substrate. A plurality of UBM layers may be provided between the plurality of TMVS and the carrier substrate. A first index matched glass may be provided on a second surface of the photonics IC. A first mold layer may be provided on the carrier substrate to surround side surfaces of the plurality of TMVs and the first index matched glass. A second surface of the first mold layer may be substantially coplanar with a second surface of the TMVs and a second surface of the first index matched glass.

In operation S120, a redistribution layer may be provided on the second surface of the plurality of TMVs, the first mold layer, and the first index matched glass. The redistribution layer may include a redistribution insulating layer in which a plurality of wiring patterns and vias are formed. The redistribution insulating layer may include one or more redistribution insulating layers.

The plurality of wiring patterns and vias may be provided as a conductive pattern, and the conductive pattern may be positioned on at least one of a first surface and a second surface of a redistribution insulating layer among the redistribution insulating layers. The plurality of wiring patterns may be provided to extend in a horizontal direction (X direction and/or Y direction) in the redistribution insulating layers. The plurality of vias may penetrate the redistribution insulating layers in the vertical direction (Z direction), to contact and be electrically connected with some of the wiring patterns. According to one or more embodiments, the plurality of vias may have a tapered shape.

In operation S130, a second index matched glass may be provided in a trench formed in the redistribution layer, and protrude away from the second surface of the redistribution layer in the vertical direction (Z direction). The second index matched glass may contact the first index matched glass.

In operation S140, a first semiconductor chip and a second semiconductor chip may be provided on the second surface of the redistribution layer. A plurality of connection pads and a plurality of connection structures may connect the first semiconductor chip and the second semiconductor chip to the redistribution layer. A second mold layer may be provided on the second surface of the redistribution layer and surround the first semiconductor chip, the second semiconductor chip, the plurality of connection pads, and the plurality of connection structures.

In operation S150, the carrier substrate may be removed to expose the plurality of UBM layer, and a plurality of external connection terminals 140 may be provided on the plurality of UBM layers to connect the redistribution layer and an external device electrically and physically.

In operation S160, a third index matched glass that is connected to fiber may be provided to contact a second surface of the second index matched glass.

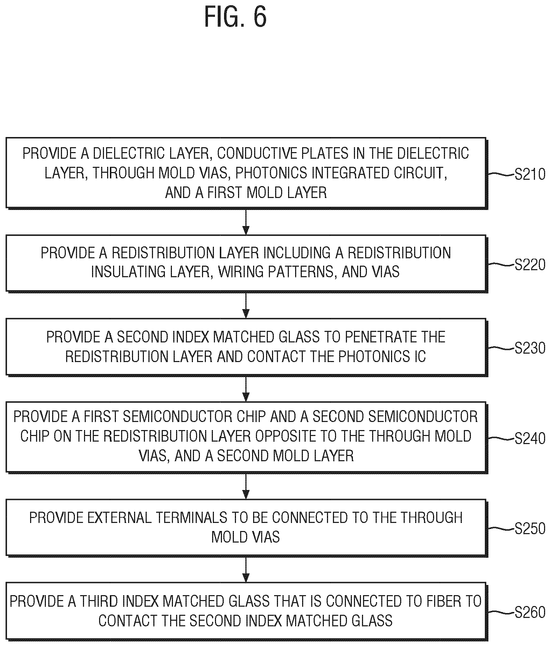

FIG. 6 illustrates a flowchart of manufacturing a semiconductor package according to one or more other embodiments. The semiconductor device manufactured through the flowchart described herebelow may the same as or correspond to the semiconductor package 1 shown in FIG. 3.

In operation S210, a dielectric layer may be provided on a carrier substrate. A conductive layer and a plurality of conductive plates thereon may be provided in the dielectric layer. A plurality of TMVs may be provided on a first surface of the dielectric layer and respectively contact first surfaces of the conductive plates. A photonics IC 20 may be provided on the second surface of the dielectric layer to be adjacent to the plurality of TMVs. A first mold layer may be provided on the dielectric layer to surround side surfaces of the plurality of TMVs and the photonics IC. A first surface of the first mold layer may be substantially coplanar with first surface of the TMVs and the second surface of the photonics IC.

In operation S220, a redistribution layer may be provided on second surface of the plurality of TMVs, the first mold layer, and the photonics IC 20. The redistribution layer may include a plurality of wiring patterns, a plurality of vias, and a redistribution insulating layer. The redistribution insulating layer may include one or more redistribution insulating layers.

The plurality of wiring patterns and vias may be provided as a conductive pattern, and the conductive pattern may be positioned on at least one of a first surface and a second surface of a redistribution insulating layer among the redistribution insulating layers. The plurality of wiring patterns may be provided to extend in a horizontal direction (X direction and/or Y direction) in the redistribution insulating layers. The plurality of vias may penetrate the redistribution insulating layers in the vertical direction (Z direction), to contact and be electrically connected with some of the wiring patterns. According to one or more embodiments, the plurality of vias may have a tapered shape.

In operation S230, a second index matched glass may be provided to penetrate the redistribution layer to contact a second surface of the photonics IC and protrude from the second surface of the redistribution layer in the vertical direction (Z direction).

In operation S240, a first semiconductor chip and a second semiconductor chip may be provided on the second surface of the redistribution layer and adjacent to the second index matched glass. A plurality of connection pads and a plurality of connection structures may connect the first semiconductor chip and the second semiconductor chip to the redistribution layer. A second mold layer may be provided on the second surface of the redistribution layer and surround the first semiconductor chip, the second semiconductor chip, the plurality of connection pads, and the plurality of connection structures.

In operation S250, a plurality of external connection terminals 140 may be provided to be connected to the plurality of TMVs.

In operation S260, a third index matched glass that is connected to fiber may be provided to contact the second surface of the second index matched glass.

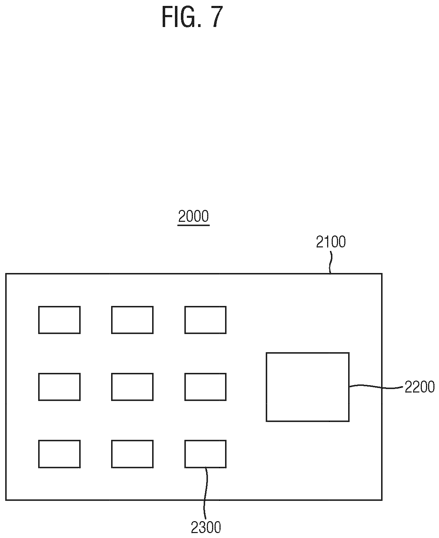

FIG. 7 illustrates a semiconductor package architecture that may incorporate the semiconductor packages according to one or more embodiments.

Referring to FIG. 7, a semiconductor package architecture 2000 according to one or more embodiments may include a processor 2200 and semiconductor devices 2300 that are mounted on a substrate 2100. The processor 2200 and/or the semiconductor devices 2300 may include one or more of semiconductor packages described in the above one or more embodiments.

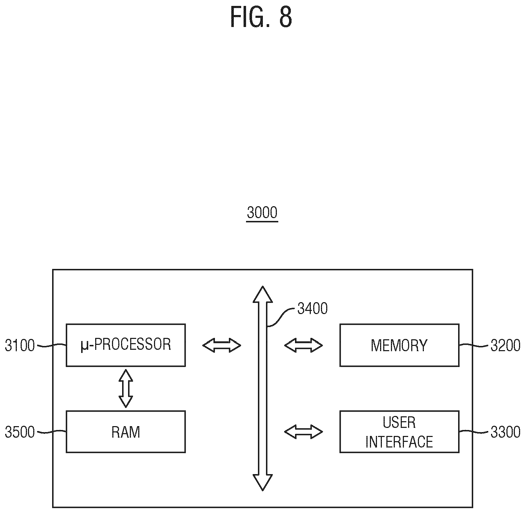

FIG. 8 illustrates a schematic block diagram of an electronic system according to one or more embodiments.

Referring to FIG. 8, an electronic system 3000 in accordance with one or more embodiments may include a microprocessor 3100, a memory 3200, and a user interface 3300 that perform data communication using a bus 3400. The microprocessor 3100 may include a CPU or an application processor (AP). The electronic system 3000 may further include a random access memory (RAM) 3500 in direct communication with the microprocessor 3100. The microprocessor 3100 and/or the RAM 3500 may be implemented in a single module or package. The user interface 3300 may be used to input data to the electronic system 3000, or output data from the electronic system 3000. For example, the user interface 3300 may include a keyboard, a touch pad, a touch screen, a mouse, a scanner, a voice detector, a liquid crystal display (LCD), a micro light-emitting device (LED), an organic light-emitting diode (OLED) device, an active-matrix light-emitting diode (AMOLED) device, a printer, a lighting, or various other input/output devices without limitation. The memory 3200 may store operational codes of the microprocessor 3100, data processed by the microprocessor 3100, or data received from an external device. The memory 3200 may include a memory controller, a hard disk, or a solid state drive (SSD).

At least the microprocessor 3100, the memory 3200 and/or the RAM 3500 in the electronic system 3000 may include semiconductor packages as described in the above embodiments.

It should be understood that the embodiments described herein should be considered in a descriptive sense only and not for purposes of limitation. Descriptions of features or aspects within each embodiment should typically be considered as available for other similar features or aspects in other embodiments.

## Claims

1. A semiconductor package comprising:
a redistribution layer;
a through mold via on a first surface of the redistribution layer;
a photonics integrated circuit on the first surface of the redistribution layer;
a first mold on the first surface of the redistribution layer, on a side surface of the through mold via, and on a side surface of the photonics integrated circuit;
a first semiconductor chip and a second semiconductor chip on a second surface of the redistribution layer opposite to the first surface of the redistribution layer;
a first glass protruding from the second surface of the redistribution layer and penetrating the redistribution layer from the first surface of the redistribution layer to the second surface of the redistribution layer;
a second mold layer on the second surface of the redistribution layer, on a side surface of the first semiconductor chip, on a side surface of the second semiconductor chip, and on a side surface of the first glass; and
a second glass on the first glass, the second glass being connected to fiber.

2. The semiconductor package according to claim 1, wherein the redistribution layer comprises:
a redistribution insulating layer;
a wiring pattern; and
a via connected to the wiring pattern, and
wherein the through mold via is connected to at least one of the wiring pattern and the via.

3. The semiconductor package according to claim 1, further comprising:
a first connection pad between the first semiconductor chip and the redistribution layer and a second connection pad between the second semiconductor chip and the redistribution layer; and
a connection structure between the connection pads and the redistribution layer, the connection structure being connected to at least one of the wiring pattern and the via.

4. The semiconductor package according to any one of claims 1 to 3, further comprising a third glass between the first glass and the photonics integrated circuit.

5. The semiconductor package according to claim 4, wherein a first surface of the first glass contacts a second surface of the third glass, and
wherein a first surface of the second glass contacts a second surface of the first glass.

6. The semiconductor package according to claim 4 or 5, wherein a refractive index of the first glass, a refractive index of the second glass, and a refractive index of the third glass are the same.

7. The semiconductor package according to any one of claims 1 to 3, further comprising a dielectric layer between the redistribution layer and the photonics integrated circuit,
wherein the first glass contacts a second surface of the photonics integrated circuit contacts a first surface of the dielectric layer.

8. The semiconductor package according to claim 7, wherein a first surface of the second glass contacts a second surface of the first glass.

9. The semiconductor package according to claim 7 or 8, wherein a refractive index of the first glass and a refractive index of the second glass are the same.

10. The semiconductor package according to any one of claims 1 to 9, further comprising:
an under bump metallurgy layer on a first surface of the through mold via; and
an external connection terminal on the under bump metallurgy layer.

11. The semiconductor package according to any one of claims 1 to 10, wherein the first semiconductor chip comprises an application-specific integrated circuit, ASIC, and the second semiconductor chip comprises a high bandwidth memory, HBM, chip.

12. A method of manufacturing a semiconductor package, the method comprising:
providing a redistribution layer;
providing a through mold via on a first surface of the redistribution layer;
provided a photonics integrated circuit on the first surface of the redistribution layer;
providing a first mold on the first surface of the redistribution layer, on a side surface of the through mold via, and on a side surface of the photonics integrated circuit;
providing a first semiconductor chip and a second semiconductor chip on a second surface of the redistribution layer opposite to the first surface of the redistribution layer;
providing a first glass to protrude from the second surface of the redistribution layer and penetrate the redistribution layer from the first surface of the redistribution layer to the second surface of the redistribution layer;
providing a second mold layer on the second surface of the redistribution layer, on a side surface of the first semiconductor chip, on a side surface of the second semiconductor chip, and on a side surface of the first glass; and
providing a second glass on the first glass, the second glass being connected to fiber.

13. The method of claim 12, wherein the providing the redistribution layer comprises:
providing a redistribution insulating layer;
providing a wiring pattern; and
providing a via connected to the wiring pattern,
wherein the through mold via is connected to at least one of the wiring pattern and the via.

14. The method of claim 12 or 13, further comprising:
providing a third glass between the first glass and the photonics integrated circuit,
wherein a first surface of the first glass contacts a second surface of the third glass, and
wherein a first surface of the second glass contacts a second surface of the first glass.

15. The method of claim 14, wherein a refractive index of the first glass, a refractive index of the second glass, and a refractive index of the third glass are the same.
